# EUROPEAN PATENT SPECIFICATION

(11) **EP 0 488 053 B1**
(45) Date of publication and mention of the grant of the patent: **17.07.1996**
(21) Application number: 91119860.4
(22) Date of filing: 21.11.1991
(51) Int. Cl.: H01L 23/544, H01L 21/304

(54) **Method for manufacturing a semiconductor chip**
Methode zur Herstellung eines Halbleiterchips
Procédé pour la fabrication d'une puce semiconductrice

(30) Priority: 29.11.1990 JP 332095/90
(43) Date of publication of application: 03.06.1992
(73) Proprietor: TOKYO SEIMITSU CO.,LTD., Mitaka-shi Tokyo (JP)
(72) Inventor: Tanaka, Toshiyuki, Mitaka-shi, Tokyo (JP); Nakamura, Masaharu, Mitaka-shi, Tokyo (JP)
(74) Representative: Hering, Hartmut, Dipl.-Ing.

(56) References cited:
- EP-A- 0 132 520
- EP-A- 0 249 762
- PATENT ABSTRACTS OF JAPAN vol. 9, no. 284 (E-357)(2007) 12 November 1985 & JP- A-60 124 952
- PATENT ABSTRACTS OF JAPAN vol. 5, no. 171 (E-80)(843) 30
- October 1981 & JP-A- 56 100 454
- RESEARCH DISCLOSURE. no. 285, January 1988, NEW YORK page 45; 'Tape Automated Bonding' Abstractnr.:28 557
- PATENT ABSTRACTS OF JAPAN vol. 8, no. 49 (E-230)(1486) 6 March 1984 & JP-A- 58 202 537 ( MITSUBISHI DENKI K.K. )
- SOLID STATE TECHNOLOGY. vol. 23, no. 7, July 1980, WASHINGTON US pages 54 - 55; G. DUNCAN: 'Proposed Alphanumeric Marking Standards for 125mm Silicon Wafers'

## Description

The present invention relates to a method for manufacturing a semiconductor chip and, in particular, to such a method which can slice out wafers in accordance with dicing data corresponding to the sizes of wafers so as to manufacture a desired semiconductor chip as well as to a combination of a wafer, a tape and a frame for carrying out the method referred to above.

A semiconductor chip manufacturing process requires data used to execute the respective manufacturing steps of the process and the data must be previously registered in a controlling computer. For the respective manufacturing steps, necessary data are called out from the controlling computer and the respective manufacturing steps are executed based on the data read out.

In order to read out such data from the controlling computer, as shown in Fig. 9, an ID number 12 is displayed in the linear part of a wafer 10 as shown and described in EP-A-0 249 762. In the respective manufacturing steps, the ID number 12 is' read and data corresponding to the ID number 12 can be read out from the controlling computer in the respective manufacturing steps. In other words, the ID number 12 serves as an identification number or symbol in the physical distribution of the wafer.

However, when the wafer is cut by a dicer, the ID number 12 may be cut off and thus the ID number 12 may not be recognized with accuracy in a step to be performed after a dicing step. For this reason, in order to solve this problem in JP-B2-64-12094 (JP-A-60-100 450) there is disclosed a method which displays an identification number (bar code pattern) corresponding to the ID number on a frame mounting a wafer thereto through a tape.

According to the above-disclosed method, there are provided means for generating a relative relation signal indicating a relative relation between the ID number and the identification number given to the frame. Due to this structure, even when the ID number is cut, the identification number on the frame can be left and, therefore, even in the step to be performed after the dicing step, by recognizing the identification number, the ID number can be identified in the long run.

In general, in a wafer manufacturing process, the wafers attached to the frame must often be stored by a lot unit in a carrier before they are delivered, or the wafer must be stored one by one into a case before it is delivered. In these cases, without recognizing the identification number registered in the frame, an operator key inputs the kind, name or the like of the wafer entered in a card or a slip attached to the carrier or case to thereby read out necessary data from a dicer or a controlling computer connected to the dicer, so that the wafer can be cut by the dicer in accordance with the data invoked.

In Patent Abstract of Japan, vol. 5, No. 171, (E-80) [843]; JP-A-56 100 454 there is disclosed an automatic processing of a semiconductor device, in which marks are attached to a substance to be processed (lead frame) and then read by read means. This lead frame is not diced in the course of the wafer processing. However, this lead frame is recycled and reused for processing other wafers accordingly, so that the mark put thereon has to be removed and changed. The respective necessary treatments are cumbersume and time consuming.

According to the disclosure of Patent Abstracts of Japan, vol. 8, no. 49, (E-230) [1486]; JP-A-58 202 537 a symbol is put on a storage case or magazine, which contains lead frames. From EP-A-0 232 520 there is known a chip identification method in semiconductor device production, according to which each chip on a wafer is, after testing, identified with identification data provided on each chip. The chip identification date is used in sorting, storing, testing, assembling and failure analyses. Thus the identification data is used for quality control.

However, in recent years, the respective steps of the wafer manufacturing process have been automated to such an extent that a plurality of machines can be operated by an operator. For this reason, it has been hard for the operator to have special knowledge of each of the machines and the wafer to be manufactured. This causes troubles to occur, makes it difficult to operate the machine quickly, and gives rise to the lowered productivity.

Accordingly, it is an object of the invention to overcome the drawbacks found in the above-mentioned wafer manufacturing methods according to the prior art and to provide a semiconductor chip manufacturing method and a combination of a wafer, a tape and a frame for carrying out the same which can be operated in a simple manner with no need of special knowledge of machines to be used and thus can enhance the productivity.

In order to accomplish the above object, according to the invention, there is provided a semiconductor chip manufacturing method as set out in claim 1.

According to the invention, a symbol indicating the kind of a wafer is recorded in a member moving together with the wafer in a chip manufacturing process, for example on the tape used to attach the wafer to the frame, as an identification number such as a bar code or the like which can be read by read means, and, when the data indicating the kind of the wafer is input, the identification number recorded on the tape can be read by the read means. For this reason, even if an operator does not have special knowledge of machines to be used in the chip manufacturing process and of wafers to be manufactured, it is possible for the operator to operate the machines with ease.

A preferred embodiment of the semiconductor chip manufacturing method is set out in claim 2.

According to a further aspect of the invention there is provided a combination of a wafer, a tape and a frame for carrying out the semiconductor chip manufacturing method outlined before as set out in claim 3.

A preferred embodiment thereof is the subject matter of claim 4.

The exact nature of this invention, as well as other objects, features and advantages thereof, will be readily apparent from consideration of the following specification relating to the accompanying drawings, in which like reference characters designate the same or similar parts throughout the figures thereof and wherein:
Fig. 1 is a plan view of a dicer employed in a semiconductor chip manufacturing device according to the invention;
Fig. 2 is a plan view of a dicer and a controlling computer employed in the invention, illustrating a relation between them;
Figs. 3 and 4 are respectively plan views of cards used in a semiconductor chip manufacturing method according to the invention;
Fig. 5 is a plan view of a wafer case for storing a wafer therein;
Fig. 6 is a plan view of a state in which the wafer case has been carried to the dicer;
Fig. 7 is a plan view of another embodiment of a semiconductor chip manufacturing method according to the invention;
Fig. 8 is a perspective view of a carrier employed in the invention, illustrating a state in which wafers are stored in the carrier;
Fig. 9 is a plan view of a wafer; and,
Fig. 10 is a plan view of a wafer and a frame according to the invention, illustrating a state in which the wafer has been mounted on the frame.

Detailed description will hereunder be given of the preferred embodiments of a method for manufacturing a semiconductor chip and a device for enforcing the same method according to the present invention with reference to the accompanying drawings.

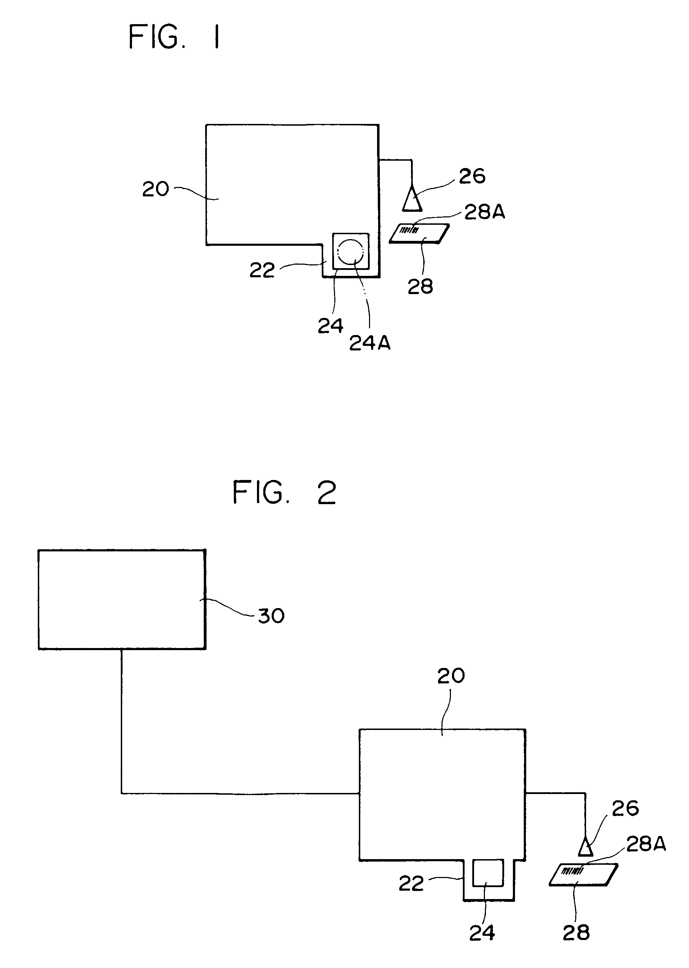

In Fig. 1, there is shown a plan view of a dicer 20. The dicer 20 includes a wafer supply part 22 which is able to receive a wafer case 24 conveyed from a previous manufacturing step. A wafer 24A is stored in the wafer case 24. Also, in the dicer 20, there is provided a bar code reader 26 which is able to recognize a bar code 28A displayed on a card 28 to be described later only tracing the surface of the card 28. The card 28 is attached to the wafer case 24 and is then conveyed together with the wafer case 24.

Also, the dicer 20, as shown in Fig. 2, is connected to a controlling computer 30 and, in general, data necessary for the dicer 20 is previously registered in the controlling computer 30. However, data not registered in the controlling computer 30 is registered in a memory part of the dicer 20 and the registered data is set to be transmittable to the controlling computer 30.

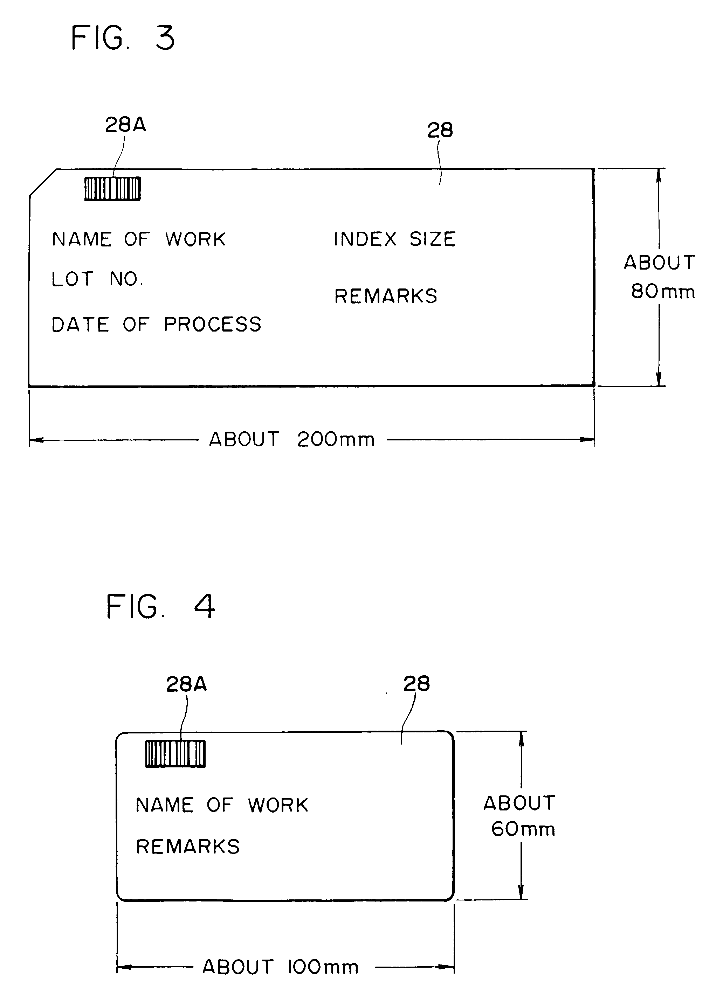

With regard to the shape and kind of the card 28 described above, such cards as shown in Figs. 3 and 4 can also be employed. A card 28 shown in Fig. 3 is formed in a so called mark sheet card size (having a length of about 200 mm, and a height of about 80 mm). A bar code 28A is displayed on the upper left portion of Fig. 3 by means of bonding, printing or similar means.

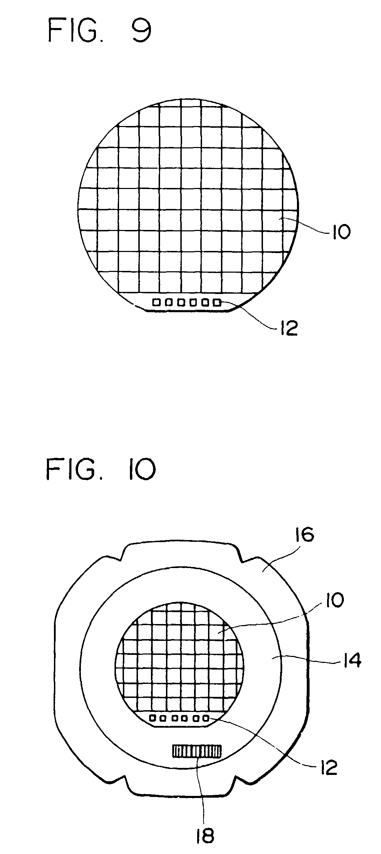

The bar code 28A is set such that it has a given relation with respect to an ID number 12 (see Fig. 9) which is displayed on the wafer 10.

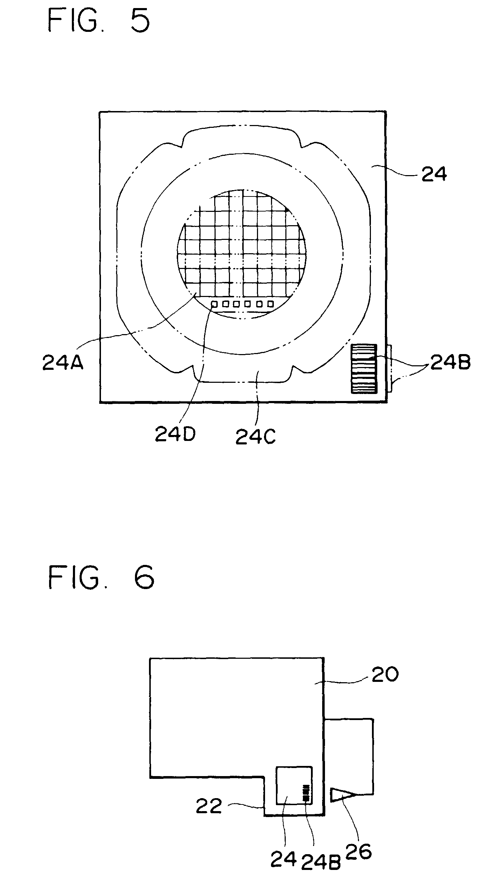

For example, it is possible to employ a method in which the number of the bar code 28A is marked as a specific value on a carrier 24 for storing the wafer 24A therein and the bar code number is managed by means of the number of frames. In other words, in a previous step to the dicer 20, when or after the wafer 24A is bonded to the frame 24C by means of a mounter (not shown), a bar code number, which is shown in Table 1 and corresponds to the kind of the wafer 24A, is marked on the carrier 24 and the marked data is managed by the controlling computer or the marked data is stored in a floppy disc, a memory card, a magnetic card or the like. And, the bar code number is registered in the card 28. In Fig. 5, 24D designates an ID number.

**Table 1**

| Kinds of Wafers | Bar Code Nos. |
|---|---|
| T S K 0 0 1 | 0 0 0 0 0 1 |
| T S K 1 0 0 | 0 1 0 0 0 0 |
| : | : |
| : | : |

For another example, the number of the bar code 28A may be set to be identical with the kind of the wafer 24A, as shown in Table 2.

**Table 2**

| Kinds of Wafers | Bar Code Nos. |
|---|---|
| T S K 0 0 1 | T S K 0 0 1 |
| T S K 1 0 0 | T S K 1 0 0 |
| : | : |
| : | : |

A user's mark, a rod No., the date of processing, a wafer size and the like can be written into the remaining spaces of the card 28.

Referring now to Fig. 4, a card 28 is formed in the shape of a so called telephone card size (having a length of about 100 mm, and a height of about 60 mm). Similarly to the card of Fig. 3, a bar code 28A is displayed in the left end portion of the card 28 and a user's mark, an index, a wafer size and the like can be written into the remaining spaces of the card 28. Also, in the magnetic portion of the back surface of the card 28, a rod No. the date of processing and the like can be registered and the data registered in such magnetic portion can be rewritten.

Next, description will be given below of the operation of the semiconductor chip manufacturing device of the invention constructed in the above-mentioned manner.

At first, the processing data of the wafers are previously registered in a controlling computer 30 shown in Fig. 2 in such a manner that the wafer processing data correspond to the ID numbers of the wafers (that is, a relation shown in Table 1 or Table 2 is registered). And, as for the data not registered in the controlling computer 30, the data are previously registered in a memory part of the dicer 20 and such data are set to be transmittable to the controlling computer 30.

Next, a bar code writer (not shown) in a previous step to the dicer 20 is used to bond or print the bar code 28A at a given position of the card 28, the card 28 is attached to the wafer case 24, and the card 28 is delivered together with the wafer case 24. When the wafer case 24 is delivered to a wafer supply part 22 of the dicer 20, then an operator takes off the card 28 attached to the wafer case 24 and the bar code reader 26 is contacted with the surface of the card 28 to thereby read out the bar code 28A.

The bar code reader 26 reads out the bar code 28A and at the same time requests necessary data from the controlling computer 30 in accordance with the signal of the bar code 28A. Responsive to this, the necessary data is applied from the controlling computer 30 to the dicer 20 and the dicer 20, in accordance with the thus applied data, aligns the wafer 24A of the wafer case 24 by use of alignment means and then cuts the wafer 24A with the rotary edges thereof into a desired semiconductor chip.

Although in the above-mentioned embodiment the controlling computer 30 is used to change the kinds of the wafers in the dicer 20, this is not limitative, but only the memory part of the dicer 20 can be used to carry out the wafer kind change. In this case, the bar code reader 26 calls out data, which corresponds to the bar code 28A read out, from the memory part of the dicer 20 and, responsive to the data called out, the dicer 20 is set to be operable (that is, the dicer 20 is switched to a state thereof suitable for machining of the wafer 24A). As a result of this, the wafer 24A can be aligned and diced.

As mentioned above, the bar code reader 26 of the dicer 20 is able to recognize the bar code 28A simply by touching the surface of the card 28 and is also able to output the thus recognized signal to the controlling computer 30 to call out the necessary data therefrom. Due to this, when the wafer 24A is diced by use of the dicer 20, there is eliminated the need for an operator to key input the data, thereby reducing the occurrences of troubles as well as enhancing the productivity of the wafers.

Also, due to the fact that the bar code reader 26 is inexpensive when compared with a recognizing device for recognizing the ID number, even if the bar code reader is provided in every wafer manufacturing step, it does not increase the cost of the wafer manufacturing line.

Further, in the above-mentioned embodiment, the bar code 28A is registered as another embodiment for displaying the ID number. However, this is not limitative, but other display means such as a magnetic card or the like can also be employed, provided that it can be recognized easily.

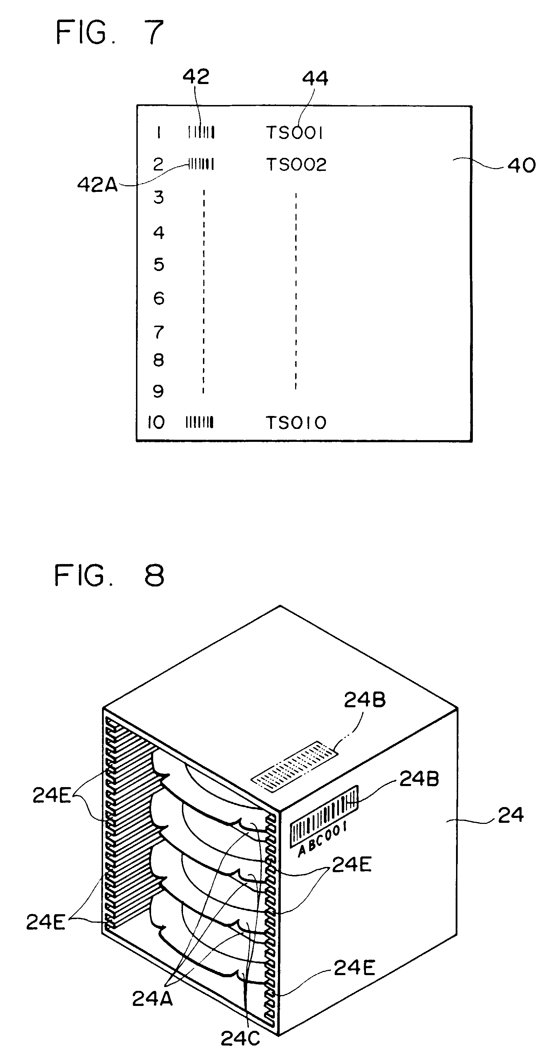

In the above-mentioned embodiment, the bar code 28A is displayed on the card 28. However, the invention is not limited to this but, as shown in Fig. 5, a bar code 24B may be displayed on the wafer carrier 24. In this case, as shown in Fig. 6, when the wafer carrier 24 is conveyed to the wafer supply part 20, the operator uses the bar code reader 26 to read the bar code 24B. By the way, Fig. 5 is a view obtained by rewriting Fig. 8 into a plan view and the bar code 24B can be displayed on the upper surface, side surface or the like of the wafer carrier 24. Also, in Fig. 8, 24E designates a groove into which the wafer 24 is mounted.

Also, in the above-mentioned embodiment, the bar code is displayed on the card 28 or on the wafer case 24. However, other way of displaying is also possible. For example, as shown in Fig. 7, a bar code 42 and a name 44 of a wafer corresponding to the bar code 42 may be previously registered in- a sheet of paper 40. When observing the wafer name (for example, TS002) displayed on the card conveyed together with the wafer, an operator may bring the bar code reader 26 into contact with a bar code 42A corresponding to the wafer name (TS002) to read the bar code 42A, thereby switching the dicer 20.

As has been described heretofore, according to method and device for manufacturing a semiconductor chip in accordance with the present invention, even without special knowledge of machines used in the present manufacturing method and wafers to be manufactured, the machines can be operated with ease so that the productivity of the wafers can be enhanced.

## Claims

1. A semiconductor chip manufacturing method comprising the steps of:
storing dicing data corresponding to various kinds of wafers (10) in a memory part of a dicer (20);
recording a symbol (18) indicating a kind of a wafer (10) on a tape (14) for attaching the wafer (10) to a frame (16) for holding the wafer (10) and moving together with the wafer (10) in a chip manufacturing process;
providing reading means (26) for reading the recorded symbol (18);
reading the recorded symbol (18) on the tape (14) with the reading means (26);
reading out dicing data from the memory part corresponding to the kind of wafer (10) indicated by the read symbol (18);
cutting the wafer (10) to a desired shape in accordance with the dicing data which is read out to thereby manufacture a semiconductor chip.

2. The semiconductor chip manufacturing method as set forth in claim 1, wherein the symbol is a bar code (18), and the reading means is a bar code reader (26).

3. A combination of a wafer (10), a tape (14) and a frame (16) for holding the wafer (10) and moving together with the wafer (10) for carrying out the seminconductor chip manufacturing method as set forth in claim 1 or 2, wherein the tape (14) attaches the wafer (10) to the frame (16) and a symbol (18) indicating a kind of the wafer (10) is recorded on the tape (14) and adapted to be read by reading means (26).

4. The combination as set forth in claim 3, wherein the symbol is a bar code (18) and the reading means is a bar code reader (26).

## Patentansprüche

1. Halbleiterchip-Herstellungsverfahren, welches die folgenden Schritte aufweist:
Speichern von Stanzdaten entsprechend unterschiedlichen Arten von Wafern (10) in einem Speicherteil einer Stanzeinrichtung (20);
Aufzeichnen eines Symbols (18), welches eine Art eines Wafers (10) wiedergibt, auf einem Band (14) zum Anbringen des Wafers (10) an einem Rahmen (16) zum Halten des Wafers (10) und zum Bewegen desselben zusammen mit dem Wafer (10) nach Abschluß eines Chip-Herstellungsverfahrens;
Vorsehen einer Leseeinrichtung (26) zum Lesen des aufgezeichneten Symbols (18);
Lesen des aufgezeichneten Symbols (18) auf dem Band (14) mit Hilfe der Leseeinrichtung (26);
Auslesen der Stanzdaten aus dem Speicherteil entsprechend der Art des Wafers (10), welche durch das gelesene Symbol nach (18) dargestellt wird;
Zuschneiden des Wafers (10) auf eine gewünschte Form nach Maßgabe der Stanzdaten, welche ausgelesen wurden, um hierdurch einen Halbleiterchip herzustellen .

2. Halbleiterchip-Herstellungsverfahren nach Anspruch 1, bei dem das Symbol ein Strichcode (18) ist und die Leseeinrichtung ein Strichcode-Leser (26) ist.

3. Kombination aus einem Wafer (10), einem Band (14) und einem Rahmen (16) zum Halten des Wafers (10) und zum Bewegen desselben zusammen mit dem Wafer (10) zur Ausführung des Halbleiter-Herstellungsverfahrens nach Anspruch 1 oder 2, bei der das Band (14) den Wafer (10) an dem Rahmen (16) hält und ein Symbol (18), welches eine Art des Wafers (10) wiedergibt, auf dem Band (14) aufgezeichnet ist und derart beschaffen ist, daß es mit Hilfe der Leseeinrichtung (26) lesbar ist.

4. Kombination nach Anspruch 3, bei der das Symbol ein Strichcode (18) ist, und die Leseeinrichtung eine Strichcode-Leseeinrichtung (26) ist.

## Revendications

1. Procédé de fabrication d'une puce semiconductrice comprenant les étapes suivantes:
stockage de données de découpe correspondant à divers types de plaquettes (10) dans une partie de mémoire d'un appareil de découpe (20);
enregistrement d'un symbole (18) indiquant un type de plaquette (10) sur une bande (14) afin de fixer la plaquette (10) à une grille (16) de maintien de la plaquette (10) et la déplacer avec la plaquette (10) lors d'un procédé de fabrication de plaquette;
fourniture d'un moyen de lecture (26) pour lire le symbole enregistré (18) ;
lecture du symbole enregistré (18) sur la bande (14) avec le moyen de lecture (26) ;
lecture de données de découpe à partir de la partie de mémoire correspondant au type de plaquette (10) indiqué par le symbole lu (18);
découpe de la plaquette (10) selon une forme souhaitée en fonction des données de découpe qui sont lues afin de fabriquer une puce semiconductrice.

2. Procédé de fabrication d'une puce semiconductrice selon la revendication 1, dans lequel le symbole est un code à barres (18), et le moyen de lecture est un lecteur (26) de code à barres.

3. Combinaison d'une plaquette (10), d'une bande (14) et d'une grille (16) pour le maintien de la plaquette (10) et se déplaçant avec la plaquette (10) pour la mise en oeuvre du procédé de fabrication de puce semiconductrice selon la revendication 1 ou 2, dans laquelle la bande (14) relie la plaquette (10) à la grille (16) et un symbole (18), indiquant le type de la plaquette (10), est enregistré sur la bande (14) et est apte à être lu par le moyen de lecture (26).

4. Combinaison selon la revendication 3, dans laquelle le symbole est un code à barres (18) et le moyen de lecture est un lecteur (26) de code à barres.
